# EUROPEAN PATENT APPLICATION

(11) **EP 1 968 120 A2**
(43) Date of publication of application: **10.09.2008**
(21) Application number: 08250709.6
(22) Date of filing: 29.02.2008
(51) Int. Cl.: H01L 31/02, H01L 31/05

(54) **Solar cell unit and solar cell module**

(30) Priority: 01.03.2007 JP 2007052007
(71) Applicant: Sanyo Electric Co., Ltd., Osaka 570-8677 (JP)
(72) Inventor: Nakatani, Shihomi, Moriguchi City Osaka 570-8677 (JP); Nakajima, Takaaki, Moriguchi City Osaka 570-8677 (JP); Kadonaga, Yasuo, Moriguchi City Osaka 570-8677 (JP); Ninomiya, Kunimoto, Moriguchi City Osaka 570-8677 (JP)
(74) Representative: Calderbank, Thomas Roger

(57) **Abstract**

A solar cell unit includes first and second solar cells (C1, C2), a first wiring member, a second wiring member, and a third wiring member. The first solar cell (C1) and the second solar cell (C2) each having a first principle surface and a second principle surface opposite the first principle surface, a polarity of the second principle surface being different from a polarity of the first principle surface. The first wiring member electrically connects electrodes, formed on surfaces pointing at a first direction, of the first solar cell (C1) and the second solar cell (C2). The second wiring member is electrically connected to an electrode, formed on a surface pointing at a second direction, of the first solar cell (C1). The third wiring member is electrically connected to an electrode, formed on a surface pointing at the second direction, of the second solar cell (C2).

## Description

This application is based upon and claims the benefit of priority from prior Japanese Patent Application No. 2007-52007, filed on March 1, 2007; the entire contents of which are incorporated herein by reference.

The present invention relates to a semiconductor device sensitive to infrared rays, visible rays and electromagnetic rays of shorter wavelength, and particularly relates to a solar cell unit and a solar cell unit each configured to convert the radiant energies of the above rays into electric energies.

### 2.

A solar cell is capable of directly converting light from the sun, which is a source having clean and inexhaustible energy, into electrical energy, so that the solar cell has attracted attention as a new environmentally-friendly energy source.

A single solar cell is able to produce only several watts at most when used as a power source (an energy source). Accordingly, in general, solar cells are not individually used, but used in the form of a solar cell module. The solar cell module includes a plurality of solar cells electrically connected in series or in parallel, as described below, and thereby is capable of producing an output of 100 or more watts.

A plurality of solar cells are connected in series with different polarities thereof alternately connected by wiring members. Here, consider a type of solar cell having a light receiving surface and a back face opposite the light receiving surface, a polarity of the back face being different from a polarity of the light receiving surface. When a plurality of such solar cells are disposed so that all the light receiving surfaces of the solar cells can have the same polarity, the light receiving surface of a solar cell and the back face of another solar cell adjacent thereto are connected to each other with a wiring member. In this case, since this wiring member requires a considerable space between the solar cells adjacent to each other, the ratio of solar cells occupying the entire solar cell module is reduced.

As an alternative to the aforementioned module, another type of solar cell module has been proposed (e.g., refer to Japanese Patent Applications Publications No. Hei 11-354822, No. 2000-315811, and No. 2002-26361). In this type of solar cell module, a plurality of solar cells are disposed with different polarities alternately arranged, and are connected to each other with wiring members in a way that a connection between light receiving surfaces of two adjacent solar cells and a connection between back faces of two adjacent solar cells are alternately made.

A process of alternately connecting the light receiving surfaces of two adjacent solar cells, and connecting the back faces of two adjacent solar cells with wiring members is usually performed in the following procedures. Here, assume that a first cell and third cell each have a p-type on the light receiving surface while a second cell has an n-type on the light receiving surface. In this case, first, the second cell is disposed next to the first cell, and the light receiving surfaces of the first and second cells are connected to each other with a wiring member. Thereafter, the third cell is disposed next to the second cell, and the back faces of the second and third surfaces are connected to each other with a wiring member. A plurality of solar cells is connected to each other in series through the repetition of the foregoing process.

As described above, a process of connecting the receiving surfaces of solar cells to each other with a wiring member, and a process of connecting the back faces of solar cells to each other with a wiring member are separately performed. Since the linear coefficient of expansion differs between a wiring member and a solar cell, a thermal stress is applied to the solar cells due to heat applied at the time of the connections with the wiring member. As a result, if a thin solar cell is employed, the solar cell is likely to be warped and be easily broken. Therefore, there has been a limitation to make the thickness of a solar cell thinner.

The present invention was made due to the above-described problems, and an object thereof is to provide a solar cell unit capable of checking the warping of a plurality of solar cells at a time of connecting the solar cells using wiring members, and to provide a solar cell module using the solar cell unit.

A solar cell unit in accordance with a first aspect of the present invention is as follows. A solar cell unit includes a first solar cell and a second solar cell; a first wiring member electrically connecting the first solar cell and the second solar cell; a second wiring member electrically connected to the first solar cell; and a third wiring member electrically connected to the second solar cell. A first solar cell and a second solar cell each has a first principle surface and a second principle surface opposite the first principle surface. The first wiring member is disposed on surfaces, pointing at a first direction, of the first solar cell and the second solar cell, and electrically connects electrodes, formed on the surfaces pointing at the first direction, of the first solar cell and the second solar cell. The second wiring member is disposed on a surface, pointing at a second direction opposite to the first direction, of the first solar cell, and electrically connected to an electrode, formed on the surface pointing at the second direction, of the first solar cell. The third wiring member is disposed on a surface, pointing at the second direction, of the second solar cell, and electrically connected to an electrode, formed on the surface pointing at the second direction, of the second solar cell.

In accordance with a first aspect of the present invention, the third wiring member may include a first extension part extended to the outside of the solar cell unit.

In accordance with another aspect thereof, the second wiring member may include a second extension part extended to the outside of the solar cell unit.

A solar cell module in accordance with a second aspect of the present invention is as follows. The solar cell module includes a first solar cell unit and a second solar cell unit, and a fourth wiring member electrically connecting the first solar cell unit and the second solar cell unit. Each of the first solar cell unit and the second solar cell unit each includes a first solar cell and a second solar cell, a first wiring member, a second wiring member, and a third wiring member. A first solar cell and a second solar cell each has a first principle surface and a second principle surface opposite the first principle surface. The first wiring member is disposed on surfaces, pointing at a first direction, of the first solar cell and the second solar cell, and electrically connects electrodes, formed on the surfaces pointing at the first direction, of the first solar cell and the second solar cell. The second wiring member is disposed on a surface, pointing at a second direction opposite to the first direction, of the first solar cell, and electrically connected to an electrode, formed on the surface pointing at the second direction, of the first solar cell. The third wiring member is disposed on a surface, pointing at the second direction, of the second solar cell, and electrically connected to an electrode, formed on the surface pointing at the second direction, of the second solar cell. The fourth wiring member electrically connects the second wiring member of the first solar cell unit and the third wiring member of the second solar cell unit.

A solar cell module in accordance with a third aspect of the present invention is as follows. The solar cell module includes a first solar cell unit and a second solar cell unit. Each of the first solar cell unit and the second solar cell unit includes a first solar cell, a second solar cell, a first wiring member, a second wiring member, and a third wiring member. The first solar cell and the second solar cell each has a first principle surface and a second principle surface opposite the first principle surface. The first wiring member is disposed on surfaces, pointing at a first direction, of the first solar cell and the second solar cell, and electrically connects electrodes, formed on the surfaces pointing at the first direction, of the first solar cell and the second solar cell. The second wiring member is disposed on a surface, pointing at a second direction opposite to the first direction, of the first solar cell, and electrically connected to an electrode, formed on the surface pointing at the second direction, of the first solar cell. The third wiring member is disposed on a surface, pointing at the second direction, of the second solar cell, and electrically connected to an electrode, formed on the surface pointing at the second direction, of the second solar cell. The third wiring member includes a first extension part extended to the respective outside of the first solar cell unit and the second solar cell unit, the first extension part of the first solar cell unit being connected to the second wiring member of the second solar cell unit.

In accordance with the third aspect of the present invention, the second wiring member may include a second extension part extended to the respective outside of the first solar cell unit and the second solar cell unit, and the second extension part of the first solar cell unit may be connected to the first extension part of the second solar cell unit.

A solar cell module in accordance with a fourth aspect of the present invention is as follows. The solar cell module includes a first solar cell unit, a second solar cell unit, and a fourth wiring member configured to electrically connect the first solar cell unit and the second solar cell unit. Each of the first solar cell unit and the second solar cell unit includes first to n-th (n being a positive integer greater than 1) solar cells, (n-1) first wiring members, a second wiring member, and a third wiring member. The first to n-th solar cells each includes a first electrode formed on a first principle surface, and a second electrode formed on a second principle surface: opposite the first principle surface. The (n-1) first wiring members, each of which is disposed on the first principle surface of a k-th (k being a positive integer in the range of 1 to n-1) solar cell and on the second principle surface of a (k+1)-th solar cell, and electrically connects the first electrode of the k-th solar cell and the second electrode of the k+1-th solar cell. The second wiring member is disposed on the second principle surface of the first solar cell, and electricaFlly connected to the second electrode of the first solar cell. The third wiring member is disposed on the first principle surface of the n-th solar cell, and electrically connected to the first electrode of the n-th solar cell. The first to n-th solar cells are arranged in order of 1 to n so that the two different polarities of the first principle surface and the second principle surface alternately are arranged. The fourth wiring member electrically connects the second wiring member of the first solar cell unit and the third wiring member of the second solar cell unit.

In the fourth aspect thereof, the above n may be an even number.
In the drawings:
Fig. 1A is a sectional view showing an entire configuration of a solar cell module of an embodiment of the present invention.
Fig. 1B is a sectional view showing a configuration of a solar cell unit configuring the solar cell module of Fig. 1A.
Fig. 2 is a flowchart showing a procedure in a method for manufacturing the solar cell module shown in Figs. 1A and 1B.
Fig. 3A is a sectional view showing a configuration of a solar cell unit of a first variation.
Fig. 3B is a view for describing a connection method of adjacent solar cell units.
Fig. 4A is a sectional view showing a configuration of a solar cell unit of a second variation.
Fig. 4B is a view for describing a connection method of adjacent solar cell units.
Fig. 5 is a sectional view showing a configuration of a solar cell unit provided with n solar cells.

An embodiment of the present invention will be described below with reference to the accompanying drawings. In the drawings, like reference numerals refer to like elements.

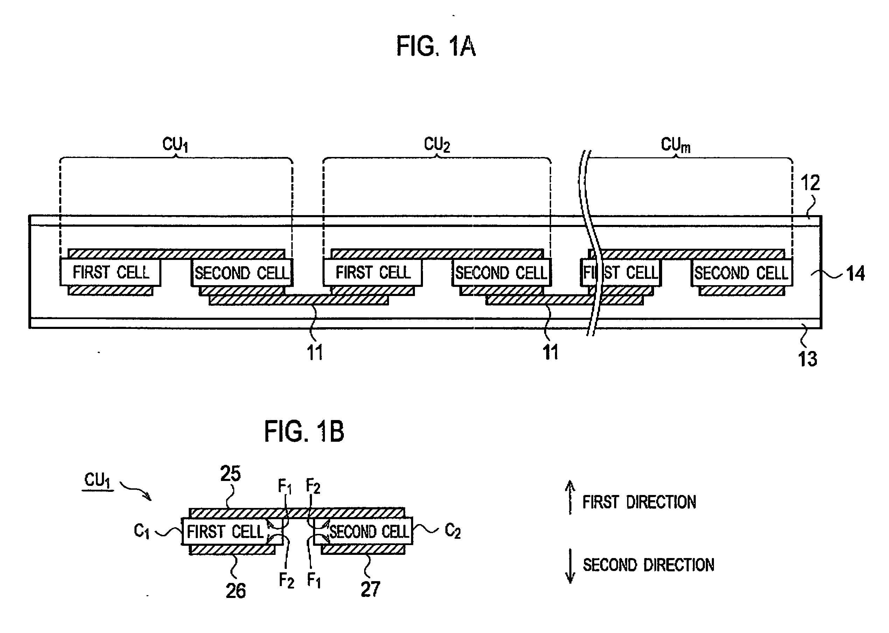

Referring to Fig. 1A, an entire configuration of a solar cell module of the embodiment of the present invention will be described. A solar cell module includes more than one solar cell units CU₁ to CUₘ, a fourth wiring member 11 electrically connecting adjacent solar cell units CU₁ to CUₘ, a sealing member 14 sealing the more than one solar cell units CU₁ to CUₘ and the wiring member 11, a glass plate 12 disposed on the side of a light receiving surface, and a back face member 13 disposed on the side of a back face opposite to the light receiving surface.

A wiring member is configured by a thin plate made of metal such as, for example, a copper foil.

Each of the solar cell units CU₁ to CUₘ includes a first cell (a first solar cell) and a second cell (a second solar cell) which are electrically connected in series or in parallel, and first to third wiring members. A configuration of the solar cell units CU₁ to CUₘ will be described later with reference to Fig. 1B. Incidentally, "m" of the CUₘ stands for an arbitrary integer greater than 1, and representing the number of solar cell units included in the solar cell module.

The fourth wiring member 11 electrically connects in series two adjacent solar cell units CU₁ to CUₘ. The number of fourth wiring members 11 included in the solar cell module is smaller by one than that (m) of the solar cell units. Incidentally, a detail of the fourth wiring members 11 will be described in the configuration of the solar cell units CU₁ to CUₘ.

The sealing member 14 protects the solar cell units CU₁ to CUₘ, which are electrically connected with the fourth wiring members 11, from external environment. For the sealing member 14, a sealing member having translucency such as, for example, EVA (Ethylene Vinyl Acetate) can be used. Instead of the glass plate 12, a light receiving surface protection member having translucency, such as translucent plastic, may be used. For example, a resin film such as a PET (Poly Ethylene Terephthalate) film, a laminated film having a structure in which Al is sandwiched between resin films, a glass plate, or a plastic plate can be used as the back member 13.

Referring to Fig. 1B, a configuration of the solar cell units CU₁ to CUₘ will be described. In the embodiment, a description is given for the case where all the solar cell units CU₁ to CUₘ included in a solar cell module have the same configurations, so that taking the solar cell unit CU₁ as an example, its configuration will be described.

The solar cell unit CU₁ includes a first solar cell C₁ and a second solar cell C₂, a first wiring member 25 electrically connecting the first solar cell C₁ and the second solar cell C₂, a second wiring member 26 electrically connected to the first solar cell C₁, and a third wiring member 27 electrically connected to the second solar cell C₂.

The first solar cell C₁ and the second solar cell C₂ each having a first principle surface and a second principle surface opposite the first principle surface, a polarity of the second principle surface being different from a polarity of the first principle surface. The first wiring member 25 is disposed on the two surfaces, pointing at a first direction, of the first and second solar cells C₁ and C₂, and electrically connects electrodes, formed on the surfaces pointing at the first direction, of the first and second solar cells C₁ and C₂ The second wiring member 26 is disposed on a surface, pointing at a second direction opposite to the first direction, of the first solar cell C₁, and electrically connected to an electrode, formed on the surface pointing at the second direction, of the first solar cell C₁. The third wiring member 27 is disposed on a surface, pointing at the second direction, of the second solar cell C₂, and electrically connected to an electrode, formed on the surface pointing at the second direction, of the second solar cell C₂.

The respective surfaces, pointing at the first direction, of the first and second solar cells C₁ and C₂ may have the same polarity or the different polarities. In the former case, a solar cell unit is configured in which the first solar cell C₁ and the second solar cell C₃ are electrically connected in parallel with the first wiring member 25, while in the latter case, another solar cell unit is configured in which the first solar cell C₁ and the second solar cell C₂ are electrically connected in series with the first wiring member 25. This embodiment of the present invention is described by taking, as an example, the solar cell units CU₁ to CUₘ in which the respective surfaces, pointing at the first direction, of the first and second solar cells C₁ and C₂, have the same polarity, and the first and second solar cells C₁ and C₂ are electrically connected in series with the first wiring member 25.

As shown in Fig. 1B, the first and second solar cells C₁ and C₂ each include a first electrode formed on a first principal surface F₁, and a second electrode formed on a second principal surface F₂ opposite to the first principal surface F₁. The first principal surface F₁ and the second principal surface F₂ has different polarities. The first wiring member 25 is disposed on the first principal surface F₁ of the first solar cell C₁ and the second principal surface F₂ of the second solar cell C₂, so that the first electrode of the first solar cell C₁ and the second electrode of the second solar cell C₂ are electrically connected. The second wiring member 26 is disposed on the second principle surface F₂ of the first solar cell C₁ so that the second wiring member 26 is electrically connected to the second electrode of the first solar cell C₁. The third wiring member 27 is disposed on the first principle surface F₁ of the second solar cell C₂ so that the third wiring member 27 is electrically connected to the first electrode of the second solar cell C₂.

The first and second solar cells C₁ and C₂ each include a photoelectric conversion body generating a photogenerated carriers due to incident light, and a pair of electrodes (the first electrode and the second electrode) for taking out the photogenerated carriers generated in the photoelectric conversion body. The pair of electrodes is formed on a light receiving surface (the first principal surface F₁) and a back face (the second principal surface F₂) . The first and second solar cells C₁ and C₂ are electrically connected in series with the first wiring member 25.

The first principle surface F₁ of the first solar cell C₁ and the second principle surface F₂ of the second solar cell C₂ are surfaces pointing at the same direction (the first direction) . Therefore, the first electrode formed on the first principle surface F₁ of the first solar cell C₁, and the second electrode formed on the second principle surface F₂ of the second solar cell C₂ are disposed so as to point at the same direction (the first direction). Meanwhile: the second principle surface F₂ of the first solar cell C₁, and the first principle surface F₁ of the second solar cell C₂ are surfaces pointing at the same direction (the second direction) . Accordingly, the second electrode formed on the second principle surface F₂ of the first solar cell C₁, and the first electrode formed on the first principle surface F₁ of the second solar cell C₂ are disposed so as to point at the same direction (the second direction).

As shown in Fig. 1A, the fourth wiring member 11 is disposed on a second wiring member 26 and a third wiring member 27 adjacent to each other, e.g., a third wiring member 27 of a first solar cell unit CU₁, and a second wiring member 26 of a second solar cell unit CU₂ so as to electrically connects the wiring members. The fourth wiring member 11, only in part, overlaps each of the second wiring member 26 and the third wiring member 27.

The photoelectric conversion body includes a semiconductor junction such as a pn junction or a pin junction, and composed of semiconductor material being single crystal semiconductor material such as single crystal Si or polycrystalline Si, thin-film semiconductor material such as Si amorphous alloy or CuInSe, or compound semiconductor material such as GaAsInP, or the like. Further, nowadays, a photoelectric conversion body using dye sensitization type organic semiconductor material, or the like has also been studied.

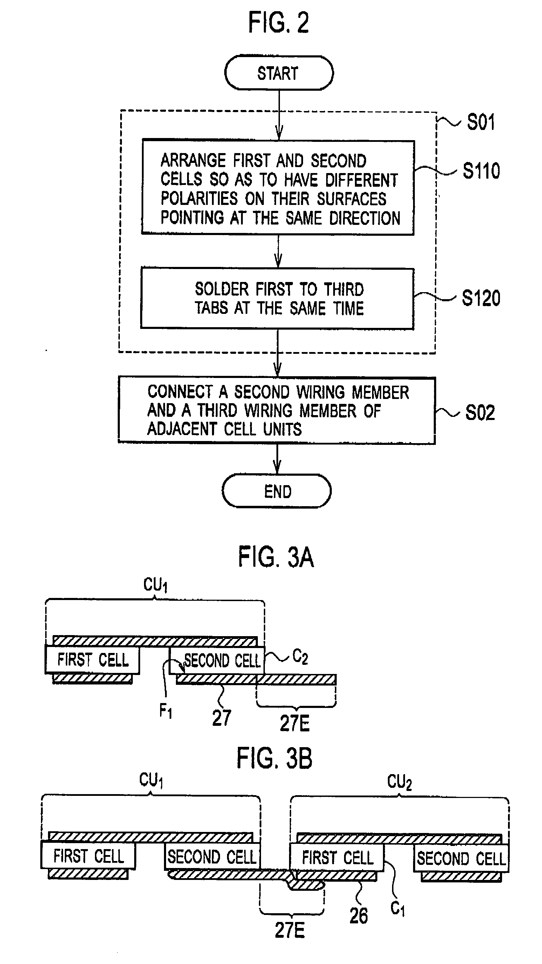

Referring to Fig. 2, a manufacturing method of the solar cell module shown in Figs. 1A and 1B will be described.
(a) Now, the description of Process S01 will be given. This is the process for manufacturing the solar cell units CU₁ to CUₘ shown in Fig. 1A and Fig. 1B. First, in Process S110, each of first solar cells C₁ and each of second solar cells C₂ are arranged to have different polarities on their surfaces pointing at the same direction. For example, when the first solar cell C₁ is disposed with an n-side electrode (the first electrode) pointing at the light receiving surface, the second solar cell C₂ is disposed with an p-side electrode (the second electrode) pointing at the light receiving surface, at a position adjacent to the first solar cell C₁.
(b) In Process S120, first to third wiring members 25 to 27 are simultaneously connected to first and second principal surfaces of first and second solar electrodes C₁, C₂- A connection between a wiring member and a solar cell is performed using solder, conductive resin, or the like. By repeating the above-described Processes, m solar cell units CU₁ to CUₘ can be manufactured.
(c) In Process 802, solar cell units adjacent to each other are electrically connected with a fourth wiring member 11. More specifically, the fourth wiring member 11 is caused to partly overlap each of a second wiring member 26 and a third wiring member 27 of solar cell units adjacent to each other, and with this overlapping retained, the fourth wiring member 11 electrically connects the second wiring member 26 and the third wiring member 27. A connection between wiring members is performed using solder, conductive resin, or the like. By performing the above-described process, a string is manufactured.
(d) Last, a plurality of strings are connected; and a glass plate 12, a sheet-like sealing member 14, a plurality of strings, a sheet-like sealing member 14, and a back face member 13 are laminated in this order, vacuumed, and thereafter pressurized and heated at 150°C for 10 minutes, so that a temporal pressure bonding is made. Thereafter, the laminated members are heated at 150°C for 1 hour so that they are completely cured. Thereafter, to the laminated members, a terminal box and a metal frame (not shown), are attached. By performing the above-described processes, the solar cell module shown in Fig. 1A can be manufactured.

As described above, in accordance with this embodiment of the present invention, the following effects are produced.

In the solar cell units CU₁ to CUₘ in accordance with this embodiment of the present invention, to the first principle surface F₁ of the first solar cell C₁ and the second principle surface F₂ of the second solar cell C₂, the first wiring member 25 is connected; to the second principle surface F₂ of the first solar cell C₁, the second wiring member 26 is connected; and to the first principle surface F₁ of the second solar cell C₂, the third wiring member 27 is connected. Accordingly, any one of the first to third wiring members 25 to 27 is connected to each of light receiving surfaces F₁ and back faces F₂ of all the first and second solar cells C₁, C₂ configuring the solar cell units CU₁ to CUₘ. Further, the first to third wiring members 25 to 27 can be connected at the same time. This simultaneous connection process can suppress the warp in solar cells, though such warp might happen if wiring members are connected to the surfaces only on one side of the solar cells.

Further, when a solar cell module is manufactured in which a large number of solar cells are connected in series or in parallel, the solar cell units CU₁ to CUₘ can be handled as one unit. In other words, a plurality of solar cell units CU₁ to CUₘ are firstly manufactured in advance, and then the wiring members of solar cell units CU₁ to CUₘ are electrically connected to each other, so that a solar cell module is manufactured. With this way, the above-described warp in a solar cell can be suppressed, which might be caused by connecting solar cells one by one in manufacturing of a solar cell module. As a result, the risk that solar cells break up is reduced, whereby solar cells become easy to handle. This enables manufacturing of solar cells with smaller thickness while reducing the manufacturing costs as well as enhancing the yield at the same time. When a defect occurs in a solar cell, a solar cell unit to which the defective solar cell belongs can be replaced, so that a replacement of the defective solar cell can be simplified.

### (First Variation)

In Fig. 1A, the second wiring member 26 and the third wiring member 27 adjacent to each other of solar cell units are electrically connected with the fourth wiring member 11, but the present invention is not limited to this connection. As shown in Fig. 3A, the third wiring member 27 is extended to the outside of the solar cell unit CU₁ so that a first extension part 27E is formed, and as shown in Fig. 3B, the first extension part 27E may be connected to a second wiring member 26 of another adjacent solar cell unit CU₂.

As shown in Fig. 3A, in the solar cell unit CU₁ of the first variation, the third wiring member 27 connected on a first principle surface F1 of the second solar cell C₂ is extended to the outside of the solar cell unit CU₁, so that the first extension part 27E can be formed. The other solar cell units CU₂ to CUₘ₋₁ configuring the solar cell module have the same configurations as that of the solar cell unit CU₁, while the solar cell unit CUₘ has a configuration shown in Fig. 1B.

As shown in Fig. 3B, a solar cell unit CU₁ and a solar cell unit CU₂ are placed a predetermined distance apart so that a part of the first extension part 27E overlaps a part of the second wiring member 26 of the solar cell unit CU₂. Thereafter, the first extension part 27E and the second wiring member 26 are connected using solder or conductive resin. The other solar cell units CU₂ to CUₘ are also connected using the same method.

Other configurations and manufacturing procedures are the same as those of this embodiment of the present invention, so that a description and drawings are omitted.

According to the first variation, the fourth wiring member 11 is not required so that manufacturing cost and time can be reduced. In Fig. 1A, connection between wiring members is performed at two spots, while in Fig. 3B, only one spot is enough for that purpose, so that a connection between solar cell units can be simplified. Since the number of spots on which two wiring members overlap each other on a cell is reduced, a convex part due to an overlap between wiring members is less likely to be formed. A sufficient electrical insulation can be secured between the glass plate 12 or the back face member 13 and a solar cell unit. The occurrences of cell break-up, cracks or the like, which are caused by the convex part in manufacturing a module, can be suppressed. Accordingly, the yield can be enhanced, and at the same time, the manufacturing of solar cells with small thickness can be achieved.

### (Second Variation)

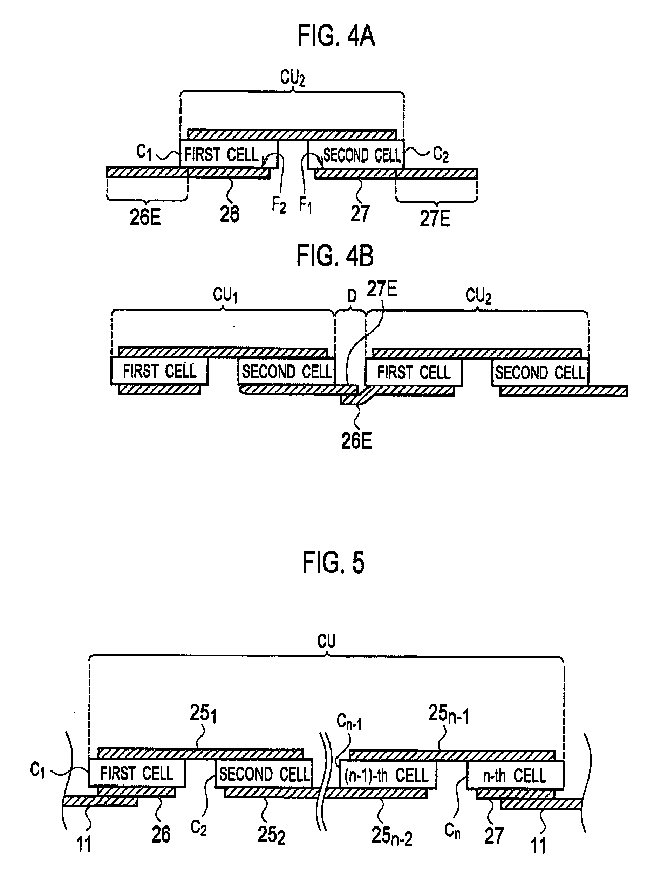

Fig. 3A shows the case in which the third wiring member 27 is extended to the outside of the solar cell unit CU₁ so that a first extension part 27E is formed, and Fig. 3B shows the case in which the first extension part 27E is connected to a second, wiring member 26 of another adjacent solar cell unit CU₂. The invention is not limited to the above, and further, as shown in Fig. 4A, the second wiring member 26 may also be extended to the outside of the solar cell unit CU₁ so that a second extension part 26E is formed.

As shown in Fig. 4A, in a solar cell unit CU₂ of the second variation, a third wiring member 27 connected on a first principle surface F₁ of a second solar cell C₂ is extended to the outside of the solar cell unit CU₂, so that a first extension part 27E is formed. Further, the second wiring member 26 connected on a second principle surface F₂ of a first solar cell C₁ is extended to the outside of the solar cell unit CU₂, so that the second extension part 26E is formed. Other solar cell units CU₃ to CUₘ₋₁ configuring the solar cell module have the same configurations as that of the solar cell unit CU₂. Further, the solar cell unit CU₁ has the same configuration as that shown in Fig. 3A. In the solar cell unit CUₘ, the second extension part 26E is formed, but the first extension part 27E is not formed.

As shown in Fig. 4B, a solar cell unit CU₁ and a solar cell unit CU₂ are placed a predetermined space D apart so that a part of the first extension part 27E and a part of the second extension part 26E overlap each other. At this time, an overlapping portion of the first extension part 27E and the second extension part 26E is positioned in the space D between the solar cell unit CU₁ and the solar cell unit CU₂. The first extension part 27E and the second extension part 26E are connected using solder or conductive resin. The other solar cell units CU₂ to CUₘ are also connected using the same method.

Other configurations and manufacturing procedures are the same as those of this embodiment of the present invention, so that a description and drawings are omitted.

In the second variation, the adjacent solar cell units are connected to each other through the connection between the first extension part 27E and the second extension part 26E, the connection is made by overlapping the first extension part 27E and the second extension part 26E. The portion on which the first extension part 27E and the second extension part 26E overlaps each other is positioned in the predetermined space D. Accordingly, there is no more spot on which different wiring members overlaps on a cell, so that a convex portion caused by the overlap of the wiring members is no longer formed. Thus, a sufficient electrical insulation can be secured between the glass plate 12 or the back face member 13 and a solar cell unit. The occurrences of cell break-up, cracks or the like, which might be caused by the convex part in manufacturing a module, can be suppressed. Accordingly, the yield can be enhanced, and at the same time, the manufacturing of solar cells with small thickness can be achieved.

### (Other Embodiment)

As described above, the present invention has been set forth in one embodiment. But it should not be understood that the discussion and the drawings constituting a part of this disclosure are interpreted to limit the present invention. It is apparent for the skilled person that various alternatives, modifications, and the practices can be achieved based on this disclosure.

In the embodiment and the first and second variations of the present invention, the number of solar cells with which one solar cell unit is provided has been two, but the invention is not limited to this number. That is, the number of solar cells provided to one solar cell unit may be more than two. Here, a description is given for the case where the number of solar cells with which one solar cell unit is provided is assumed to be n (n being an integer greater than 1.).

AS shown in Fig. 5, a solar cell unit CU includes at least first to n-th solar cells C₁ to Cₙ, first wiring members 25₁ to 25ₙ₋₁ electrically connecting adjacent solar cell units, a second wiring member 26 electrically connected to the first solar cell unit CU₁, and a third wiring member 27 electrically connected to the n-th solar cell Cₙ.

The first to n-th solar cells C₁ to Cₙ each include a first electrode formed on a first principle surface thereof, and a second electrode formed on a second principle surface thereof. The (n-1) first wiring members 25₁ to 25ₙ₋₁ are each disposed on the first principle surface of a k-th (k being a positive integer in the range of 1 to n-1) solar cell Cₖ, and on the second principle surface of a (k+1) -th solar cell Cₖ₊₁, so that the (n-1) first wiring members 25₁ to 25ₙ₋₁ each connects the first electrode of the k-th solar cell Cₖ, and the second electrode of the (k+1)-th solar cell Cₖ₊₁. The second wiring member 26 is disposed on the second principle surface of the first solar cell C₁, and connected to the second electrode of the first solar cell C₁. The third wiring member 27 is disposed on the first principle surface of the n-th solar cell Cₙ, and connected to the first electrode of the n-th solar cell Cₙ.

The solar cell module includes more than one solar cell unit CU shown in Fig. 5, and further includes a fourth wiring member 11 electrically connecting adjacent solar cell units CU.

The first to n-th solar cells C1 to Cₙ are arranged in order of 1 to n so that the two different polarities of the first principle surface and the second principle surface alternately are arranged. For example, when the first solar cell Cl is disposed with an n-side electrode placed on the side of the light receiving surface, the second solar cell C₂ adjacent to the first solar cell C1 is disposed with a p-side electrode placed on the side of the light receiving surface. The third solar cell C3 adjacent to the second solar cell C2 is disposed with an n-side electrode placed on the side of the light receiving surface. In the same manner, the fourth to n-th solar cells C₄ to Cₙ are arranged while two different polarities are alternately arranged.

The fourth wiring member 11 electrically connects the second wiring member 26 and the third wiring member 27 of adjacent solar cell units. Further, as shown in the first and second variations, instead of the fourth wiring member 11, the first extension part 27E and the second extension part 26E may be used for the connection.

Incidentally, it is preferable that the number (n) of the solar cells C₁ to Cₙ with which one solar cell unit CU is provided be an even number. This enables the fourth wiring members 11 to be gathered on one side of back faces and light receiving surfaces. Specifically, since convex parts formed due to overlaps of wiring members can be gathered on one side of the back faces and the light receiving surfaces, an electric insulation can be easily secured between the glass plate 12 or the back surface material 13 and a solar cell unit.

Thus, it is to be understood that the invention encompasses many other embodiments not described above. Therefore, the scope of the present invention is indicated by the appended claims relevant to the foregoing disclosure, as interpreted by the description and drawings.

## Claims

1. A solar cell unit, comprising:
a first solar cell and a second solar cell ;
a first wiring member disposed on surfaces, pointing at a first direction, of the first solar cell and the second solar cell, the first wiring member configured to electrically connect electrodes, formed on the surfaces pointing at the first direction, of the first solar cell and the second solar cell;
a second wiring member disposed on a surface, pointing at a second direction opposite to the first direction, of the first solar cell, the second wiring member electrically connected to an electrode, formed on the surface pointing at the second direction, of the first solar cell; and
a third wiring member disposed on a surface, pointing at the second direction, of the second solar cell, the third wiring member electrically connected to an electrode, formed on the surface pointing at the second direction, of the second solar cell.

2. The solar cell unit according to claim 1, wherein
the third wiring member includes a first extension part extended to the outside of the solar cell unit.

3. The solar cell unit according to claim 2, wherein
the second wiring member includes a second extension part extended to the outside of the solar cell unit.

4. A solar cell module, comprising:
a first solar cell unit and a second solar cell unit, and
a fourth wiring member configured to electrically connect the first solar cell unit and the second solar cell unit,
wherein the first solar cell unit and the second solar cell unit each includes:
a first solar cell and a second solar cell;
a first wiring member disposed on surfaces, pointing at a first direction, of the first solar cell and the second solar cell, the first wiring member configured to electrically connect electrodes, formed on the surfaces pointing at the first direction, of the first solar cell and the second solar cell;
a second wiring member disposed on a surface, pointing at a second direction opposite to the first direction, of the first solar cell, the second wiring member electrically connected to an electrode, formed on the surface pointing at the second direction, of the first solar cell; and
a third wiring member disposed on a surface, pointing at the second direction, of the second solar cell, the third wiring member electrically connected to an electrode, formed on the surface pointing at the second direction, of the second solar cell, and
wherein the fourth wiring member electrically connects the second wiring member of the first solar cell unit and the third wiring member of the second solar cell unit.

5. A solar cell module, comprising:
a first solar cell unit and a second solar cell unit,
wherein the first solar cell unit and the second solar cell unit each includes:
a first solar cell and a second solar cell;
a first wiring member disposed on surfaces, pointing at a first direction, of the first solar cell and the second solar cell, the first wiring member configured to electrically connect the electrodes, formed on the surfaces pointing at the first direction, of the first solar cell and the second solar cell;
a second wiring member disposed on a surface, pointing at a second direction opposite to the first direction, of the first solar cell, the second wiring member electrically connected to an electrode, formed on the surface pointing at the second direction, of the first solar cell; and
a third wiring member configured to be disposed on a surface, pointing at the second direction, of the second solar cell, the third wiring member electrically connected to an electrode, formed on the surface pointing at the second direction, of the second solar cell, and
wherein the third wiring member includes a first extension part extended to the respective outside of the first solar cell unit and the second solar cell unit, and
the first extension part of the first solar cell unit is connected to the second wiring member of the second solar cell unit.

6. The solar cell module according to claim 5, wherein
the second wiring member includes a second extension part extended to the respective outside of the first solar cell unit and the second solar cell unit, and
the second extension part of the first solar cell unit is connected to the first extension part of the second solar cell unit.

7. A solar cell module, comprising:
a first solar cell unit and a second solar cell unit, and
a fourth wiring member configured to electrically connect the first solar cell unit and the second solar cell unit,
wherein the first solar cell unit and the second solar cell unit each including:
first to n-th (n is a positive integer greater than 1) solar cells each including a first electrode formed on a first principle surface and a second electrode formed on a second principle surface opposite the first principle surface;
(n-1) first wiring members each disposed on the first principle surface of a k-th (k being a positive integer in the range of 1 to n-1) solar cell, and on the second principle surface of a (k+1)-th solar cell, the (n-1) first wiring members configured to electrically connect the first electrode of the k-th solar cell and the second electrode of the k+1-th solar cell;
a second wiring member disposed on the second principle surface of the first solar cell, the second wiring member electrically connected to the second electrode of the first solar cell; and
a third wiring member disposed on the first principle surface of the n-th solar cell, the third wiring member electrically connected to the first electrode of the n-th solar cell, and
wherein the first to n-th solar cells are arranged in order of 1 to n so that the two different polarities of the first principle surface and the second principle surface alternately are arranged, and
the fourth wiring member electrically connects the second wiring member of the first solar cell unit and the third wiring member of the second solar cell unit.

8. The solar cell module according to claim 7, wherein the above n is an even number.
